(19) Europäisches Patentamt / European Patent Office / Office européen des brevets

(11) **EP 1 815 536 B1**

(12) **EUROPEAN PATENT SPECIFICATION**

(45) Date of publication and mention
of the grant of the patent:
**09.02.2011 Bulletin 2011/06**

(21) Application number: **05809900.3**

(22) Date of filing: **09.11.2005**

(51) Int Cl.:
*H01L 33/50* (2010.01)     *H01L 51/50* (2006.01)

(86) International application number:
**PCT/IB2005/053684**

(87) International publication number:
**WO 2006/054204 (26.05.2006 Gazette 2006/21)**

(54) **Light source with improved dimming behavior and method of driving the light source**

Lichtquelle mit verbessertem abdunkelungsverhalten und Methode zu derer Ansteuerung

Source lumineuse avec comportement d'attenuation amélioré et sa méthode de commande

(84) Designated Contracting States:
**AT BE BG CH CY CZ DE DK EE ES FI FR GB GR HU IE IS IT LI LT LU LV MC NL PL PT RO SE SI SK TR**

(30) Priority: **18.11.2004 EP 04105907**

(43) Date of publication of application:
**08.08.2007 Bulletin 2007/32**

(73) Proprietors:
• **Philips Intellectual Property & Standards GmbH**
**20099 Hamburg (DE)**
Designated Contracting States:
**DE**
• **Koninklijke Philips Electronics N.V.**
**5621 BA Eindhoven (NL)**

(72) Inventors:
• **JÜSTEL, Thomas**
**c/o Philips Intellectual Property & Standards GmbH**
**52066 Aachen (DE)**

• **SCHOLL, Robert, P.**
**c/o Philips Intellectual Property & Standards GmbH**
**52066 Aachen (DE)**
• **BUSSELT, Wolfgang**
**c/o Philips Intellectual Property & Standards GmbH**
**52066 Aachen (DE)**
• **SCHMIDT, Peter**
**c/o Philips Intellectual Property & Standards GmbH**
**52066 Aachen (DE)**

(74) Representative: **Bekkers, Joost J.J et al**
**Philips**
**Intellectual Property & Standards**
**P.O. Box 220**
**5600 AE Eindhoven (NL)**

(56) References cited:
**US-A- 4 152 711     US-A1- 2004 203 312**

**Description**

FIELD OF THE INVENTION

The invention relates to a light source comprising a light emitting device and a luminescent cover. More specifically the invention relates to a light source comprising at least one light emitting device capable of emitting electromagnetic radiation in the range from near UV to blue in response to a driving signal of a driving means and a luminescent cover at least comprising a first activator and a second activator to convert said electromagnetic radiation into visible light. The invention also relates to a method for dimming a light source of the above mentioned type.

BACKGROUND OF THE INVENTION

For the realization of white solid state light sources, blue light emitting diodes based on the semiconductor (In, Ga)N, as described by S. Nakamura et al. (Appl. Phys. Lett. 67, 1995, 1868), are widely applied. The light source works as an efficient pump exciting a luminescent material which returns to its ground state by emitting green, yellow or red light. Additive color mixing results in a broadband spectrum, which is perceived as white light.

In 1996, Nichia Chemical Industries Ltd. introduced a white LED, that uses a luminescent layer comprising $Y_3Al_5O_{12}$:Ce (YAG:Ce) or $(Y,Gd)_3(Al_{1-x}Ga_x)_5O_{12}$:Ce (YAGaG:Ce) to convert blue light emitted by an (In,Ga)N LED into a broad band yellow emission spectrum, that peaks at about 565 nm. The emission band is sufficiently broad to produce white light in the color temperature (CT) range from 5000 - 8000 K, and a color rendering index (CRI) of about 75 - 85. The CT of a light source is defined as the temperature of a black body radiator that has the same color. The CRI of a light source is a rating that represents the degree of the resulting color shift of a test object under that light source in comparison with its color under a standard lamp of the same temperature.

The above light sources have the shortcoming that a low color temperature and a high color rendering index cannot be obtained. US 2002/158565 discloses phosphor blends comprising a mixture of at least two phosphors. By mixing appropriate proportions of the phosphors, composites of emission spectra may be created that provides a desired CT and CRI.

US 4152711A discloses a light source having a light-emitting device and a luminescent cover comprising an activator, and driving means adapted to control the spectrum of the emitted visible light.

A problem associated with the prior art is that dimming of these light sources does not result in a perceivable color point shift to the red spectral range as it is known from incandescent lamps and natural daylight. In particular, indoor lighting applications require white light sources with an incandescent lamp like color temperature and a dimming behavior similar to that of an incandescent lamp.

SUMMARY OF THE INVENTION

It is an object of the invention to provide a light source of the above described type with a dimming characteristic substantially resembling the spectral variation of an incandescent lamp on dimming.

This object is accomplished by providing a light source comprising at least one light emitting device capable of emitting electromagnetic radiation in the range from near ultraviolet to blue in response to a driving signal of driving means and a luminescent cover at least comprising a first activator ($A_1$) and a second activator ($A_2$) to convert said electromagnetic radiation into visible light, wherein said first activator and said second activator have different response characteristics and said driving means is adapted to vary said driving signal to control the spectrum of said visible light for said light source. The variation of the driving signal results in a variation of the electromagnetic radiation from the light emitting device that interacts with luminescent cover. As a consequence of the different response characteristics of the first and second activator, the conversion of the electromagnetic radiation to visible light changes with the variation of the driving signal. Accordingly, the visible light spectrum can be controlled to achieve the desired dimming behavior of the light source.

In particular, the driving signal is a pulsed driving signal and said driving means is adapted to vary the pulse width of said pulsed driving signal. In this embodiment, the relation between the pulse width and the response characteristics of the first and second activators determine the spectrum of the visible light of the light source. By varying the pulse width, the spectrum of the visible light varies as a result of this relation.

The embodiment of the invention, wherein said light emitting device is a solid state light source, such as an organic light emitting diode or a semiconductor light emitting diode, preferably of InGaN or AlInGaN material had the advantage that such light sources are able to emit electromagnetic radiation that can be absorbed by the luminescent cover.

The embodiment of the invention wherein said first activator ($A_1$) is a fast activator with a response time $\tau_{1/e}$ in the range of 10 nanoseconds-100 microseconds and said second activator ($A_2$) is a slow activator with a response

time $\tau_{1/e}$ in the range of 10 microseconds - 100 milliseconds is advantageous in that the defined ranges for the response have been found to result into desired behavior of the spectral variation of the visible light output.

The embodiment of the invention wherein said fast activator is a green light emitting activator and said slow activator is a red light emitting activator has the advantage that a white light emitting light source can be obtained.

The embodiment of the invention, wherein said first activator and said second activator are part of a single luminescent composition, has the advantage that such a light source is relatively easy to produce and relatively inexpensive.

Preferred compositions are compositions, wherein said first activator and said second activator are selected from the group (first activator, second activator) comprising $(Eu^{2+}, Mn^{2+})$, $(Ce^{3+}, Mn^{2+})$, $(VO_4^{3-}, Eu^{3+})$ and $(Bi^{3+}, Eu^{3+})$ doped into a host lattice selected from the group based on sulphides, oxysulphides, oxides, oxynitrides and nitrides.

However, luminescent compositions wherein said first activator and said second activator each are part of different luminescent compositions can be used as well.

Preferred compositions are compositions, wherein said first activator is selected from the group comprising $Eu^{2+}$, $Ce^{3+}$, $VO_4^{3-}$ and $Bi^{3+}$ doped into a first host lattice of green light emitting material and said second activator is selected from the group comprising $Mn^{2+}$ and $Eu^{3+}$ doped into a second host lattice of red light emitting material.

It is noted that the above embodiments, or aspects thereof, may be combined.

The invention also relates to a method of dimming a light source as described above, in particular by applying a pulsed driving signal to said light emitting device and varying the pulse width of said pulsed driving signal. The effect and advantage of such a step has been discussed with reference to the light source.

The invention will be further illustrated with reference to the attached drawings, which schematically show a preferred embodiment according to the invention. It will be understood that the invention is not in any way restricted to this specific and preferred embodiment.

BRIEF DESCRIPTION OF THE DRAWINGS

In the drawings:

Fig. 1 schematically displays a light source according to an embodiment of the invention;
Fig. 2 displays driving signals for the light source of Fig. 1 according to an embodiment of the invention;
Fig. 3 shows experimental results of variation of the spectra for the visible light of the light source of Fig. 1, and
Fig. 4 shows a CIE 1931 diagram.

DETAILED DESCRIPTION OF THE DRAWINGS

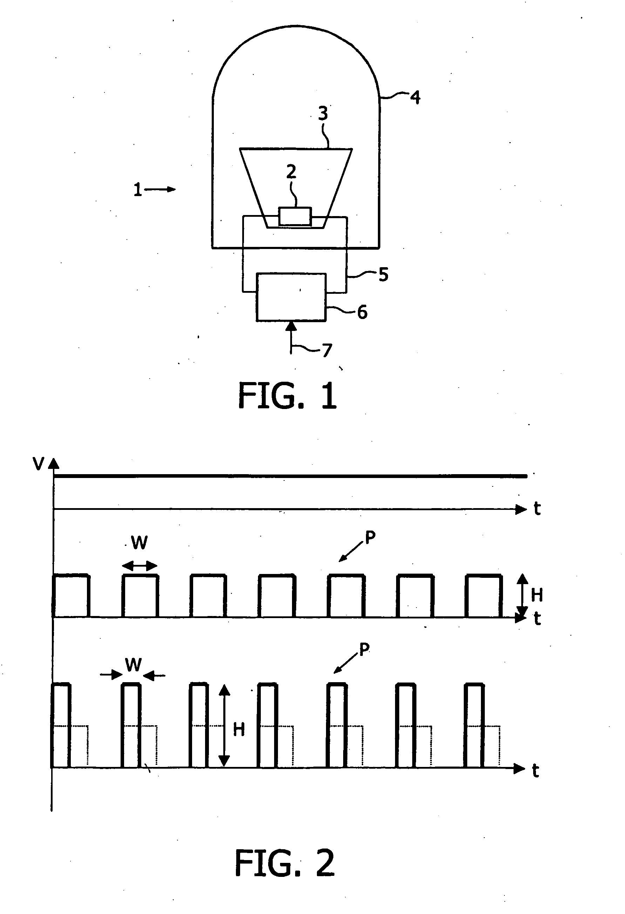

Fig. 1 schematically displays a light source 1 comprising a light emitting device 2 and a luminescent cover 3 provided in an encapsulation 4 transparent for visible light. The light emitting device 2 is connected by leads 5 to a driving means 6 to provide the light emitting device 2 with driving signals, illustrated in Fig. 2. The driving means 6 may be an integral part of the light source 1 or an externally provided driving means.

The light emitting device 2 is a solid state light emitting device, such as an organic light emitting diode (LED) or a semiconductor LED. As an example, the LED 2 is a InGaN LED. The LED 2 is capable of emitting electromagnetic radiation in the range from near UV to blue, i.e. in the range of 350 to 490 nm, in response to a driving signal of a driving means 6. As an example, the InGaN LED 2 emits electromagnetic radiation with a wavelength of 460nm.

The LED 2 serves as an excitation source for the luminescent cover 3 that is deposited or coated on or over the LED 2 such that the electromagnetic radiation of the LED 2 can be received. The luminescent cover 3, hereinafter also referred to as cover 3, comprises a first activator $A_1$ and a second activator $A_2$. Both activators $A_1$, $A_2$ convert the incident electromagnetic radiation from the LED 2 into visible light, whereby the emission spectra of the two components are referred to as $Sp_1(\lambda)$ and $Sp_2(\lambda)$ respectively. The incident electromagnetic radiation is indicated by $Sp_0(\lambda)$. According to the present embodiment of the invention the two activators $A_1$, $A_2$ have different response characteristics or saturation behavior which can e.g. be achieved by different doping levels or by different nature of the activators $A_1$, $A_2$.

The first activator $A_1$ is a fast activator with a response time $\tau_{1/e}$ in the range of 10 nanoseconds - 100 microseconds and said second activator $A_2$ is a slow activator with a response time $\tau_{1/e}$ in the range of 10 microseconds - 100 milliseconds. The fast activator is a green light emitting activator and the slow activator is a red light emitting activator to obtain a white light emitting light source 1.

The first and second activators $A_1$, $A_2$ may be contained in a single host lattice ($HL:A_1, A_2$, with HL = host lattice, $A_1$=first activator, $A_2$=second activator), i.e. the first activator $A_1$ and said second activator $A_2$ are part of a single luminescent composition. The first activator $A_1$ and second activator $A_2$ are selected from the group (first activator, second activator) comprising $(Eu^{2+}, Mn^{2+})$, $(Ce^{3+}, Mn^{2+})$, $(VO_4^{3-}, Eu^{3+})$ and $(Bi^{3+}, Eu^{3+})$ doped into a host lattice HL selected from the group based on sulphides, oxysulphides, oxides, oxynitrides and nitrides. As an example the compo-

sition CaS: $Ce^{3+}, Mn^{2+}$ is used.

Alternatively, separate host lattices ($HL_1:A_1$ and $HL_2:A_2$ with $HL_1$=host lattice 1 and $HL_2$=host lattice 2) are employed, i.e. the first activator $A_1$ and second activator $A_2$ are part of different luminescent compositions. The first activator $A_1$ is selected from the group comprising $Eu^{2+}, Ce^{3+}, VO_4^{3-}$ and $Bi^{3+}$ doped into the first host lattice $HL_1$ of green light emitting material and the second activator $A_2$ is selected from the group comprising $Mn^{2+}$ and $Eu^{3+}$ doped into a second host lattice $HL_2$ of red light emitting material. Green-emitting materials showing a strong absorption in the blue and near ultraviolet are e.g. $CaS:Ce^{3+}$), $SrGa_2S_4:Eu^{2+}$), $(Ba,Sr)_2SiO_4:Eu^{2+}$, or $(Ba,Sr)Si_2N_2O_2:Eu^{2+}$. The red-emitting luminescent composition will be activated by a slow activator, such as $Mn^{2+}$ or $Eu^{3+}$. An example is $Y_2O_2S:Eu^{3+}$.

The driving means 6 may comprise a pulse generator of low voltage pulses in the range of 2-10 Volts supplied to the LED 2 in order to generate the spectrum $Sp_0(\lambda)$ of the electromagnetic radiation.

Under continuous drive, i.e. the electrical input power of the LED 2 is constant over time *t* as shown in the upper diagram of Fig. 2, both phosphors are evenly excited and the effective spectrum emitted by the LED is given by

$$Sp_{total}(\lambda) = \alpha *Sp_0(\lambda) + Sp_1(\lambda) + Sp_2(\lambda)$$

wherein $\alpha$ is the fraction of non-converted primary electromagnetic radiation from the LED 2.

In contrast, according to the present embodiment of the invention, the driving signal of the driving means 6 is a discontinuous pulse drive as shown in the middle diagram of Fig. 2. As the response time of the second activator $A_2$ or phosphor is larger than that of the first activator $A_1$, the effective spectrum obtained from the light source 1 is given by

$$Sp_{total}(\lambda) = \alpha*Sp_0(\lambda) + Sp_1(\lambda) + \varepsilon*Sp_2(\lambda)$$

wherein $\varepsilon = 0...1$ = degree of saturation of the second activator/phosphor.

According to an embodiment of the invention, the driving signal is a pulsed driving signal P and the driving means 6 is adapted to vary the pulse width W of the pulsed driving signal P, indicated by the arrow 7 in Fig. 1. In other words, the duty cycle of the LED 2 is adjusted, as displayed in the lower diagram of Fig. 2 illustrating a duty cycle of 50%. In reducing the duty cycle, the total input power is dissipated by the LED 2 in a shorter time interval, whereas the average input power remains equal to the case continuous drive shown in the upper diagram of Fig. 2. In this manner, the CT of the light source 1 can be tuned by controlling the width W and height H of the pulsed driving signal P.

By modulating the pulse width W of the driving signal P for the LED 2 comprising a cover 3 according to the above mentioned compositions, the spectrum of the visible light can be tuned due to the saturation of the red-emitting component in the spectrum. This feature is desired in all application areas where incandescent or halogen lamps are replaced for economic reasons. Presently, mostly energy saving lamps are installed for this purpose, although the color point of this lamp type shifts to the blue if they are dimmed.

This problem is reduced or eliminated by the present invention. This embodiment involves the application of a blue light emitting LED 2 comprising a luminescent cover 3, that contains a phosphor exploiting one of the above-mentioned ion couples.

EXAMPLE

A CaS: $Ce^{3+}$, $Mn^{2+}$ phosphor powder is suspended into a silicon precursor used for the flexible filling of the cover 3. Typically, the phosphor concentration in the suspension allows deposition between 10 and 300 $\mu$g of phosphor onto the LED 2 with a surface area of about 1 $mm^2$. A catalyst is added to polymerize the silicon precursor, and the LED 2 is sealed by a transparent plastic encapsulation 4.

The 460 nm emitting InGaN LED 2 is driven by a pulse generator 6 that supplies rectangle pulses (2 - 10 V) at a frequency of 10 kHz. The duration of the rectangle pulses is between 0.1 and 100 $\mu$s, thus corresponding to a duty cycle of 0.1 to 100%.

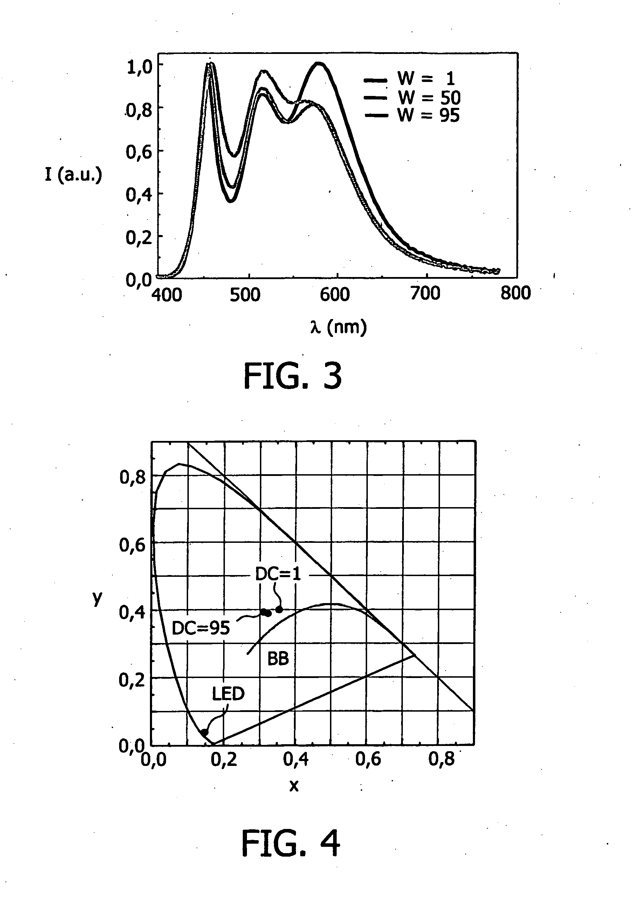

Fig. 3 shows emission spectra for LEDs 2 driven at a frequency of -10kHz with a pulse width W of 1 $\mu$s (black) corresponding to a duty cycle DC of 1%, 50 $\mu$s (dark gray) corresponding to a duty cycle DC of 50 % and 95 $\mu$s (light gray) corresponding to a duty cycle DC of 95%.

Fig. 4 shows a CIE 1931 color diagram displaying the change in the CT as a result of the variation of the duty cycle.

It should be noted that the above-mentioned embodiments illustrate, rather than limit, the invention, and that those skilled in the art will be able to design many alternative embodiments without departing from the scope of the appended claims. The gist of the invention relates to the insight that variation of the driving signal allows an adequate dimming behavior for a light source with activators having different response characteristics. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The mere fact that certain measures are recited in mutually different dependent claims does not indicate that a combination of these measures cannot be used to advantage.

## Claims

1. A light source (1) comprising at least one light emitting device (2) capable of emitting electromagnetic radiation in the range from near ultraviolet to blue in response to a driving signal of driving means (6) and a luminescent cover (3) to convert said electromagnetic radiation into visible light, **characterised in that** the luminescent cover comprises at least a first activator ($A_1$) and a second activator ($A_2$), wherein said first activator and said second activator have different response characteristics and said driving means is adapted to vary said driving signal to control the spectrum ($Sp_{total}(\lambda)$) of said visible light for said light source.

2. The light source (1) according to claim 1, wherein said driving signal is a pulsed driving signal (P) and said driving means (6) is adapted to vary the pulse width (W) of said pulsed driving signal.

3. The light source (1) according to claim 1, wherein said light emitting device (2) is a solid state light source, such as an organic light emitting diode or a semiconductor light emitting diode, preferably of InGaN or AlInGaN material.

4. The light source (1) according to claim 1, wherein said first activator ($A_1$) is a fast activator with a response time $\tau_{1/e}$ in the range of 10 nanoseconds - 100 microseconds and said second activator ($A_2$) is a slow activator with a response time $\tau_{1/e}$ in the range of 10 microseconds -100 milliseconds.

5. The light source (1) according to claim 4, wherein said fast activator is a green light emitting activator and said slow activator is a red light emitting activator.

6. The light source (1) according to claim 1, wherein said first activator and said second activator are part of a single luminescent composition.

7. The light source (1) according to claim 6, wherein said first activator and said second activator are selected from the group (first activator, second activator) comprising ($Eu^{2+}$, $Mn^{2+}$), ($Ce^{3+}$, $Mn^{2+}$), ($VO_4^{3-}$, $Eu^{3+}$) and ($Bi^{3+}$, $Eu^{3+}$) doped into a host lattice selected from the group based on sulphides, oxysulphides, oxides, oxynitrides and nitrides.

8. The light source (1) according to claim 1, wherein said first activator and said second activator each are part of different luminescent compositions.

9. The light source according to claim 8, wherein said first activator is selected from the group comprising $Eu^{2+}$, $Ce^{3+}$, $VO_4^{3-}$ and $Bi^{3+}$ doped into a first host lattice of green light emitting material and said second activator is selected from the group comprising $Mn^{2+}$ and $Eu^{3+}$ doped into a second host lattice of red light emitting material.

10. A method for dimming a light source comprising at least one light emitting device (2) capable of emitting electromagnetic radiation in the range from near UV to blue in response to a driving signal of a driving means (6) and a luminescent cover (3) to convert said electromagnetic radiation into visible light, the method comprising the step of varying said driving signal to control the spectrum of said visible light, and being **characterised in that** the luminescent cover at least comprises a first activator and a second activator, wherein said first activator and said second activator have different response characteristics.

11. The method according to claim 10 comprising the step of applying a pulsed driving signal to said light emitting device and varying the pulse width of said pulsed driving signal.

## Patentansprüche

1. Lichtquelle (1) mit wenigstens einer Leuchtanordnung (2) die imstande ist, elektromagnetische Strahlung in dem Bereich von nahezu Ultraviolett bis Blau zu emittieren, und zwar in Reaktion auf ein Steuersignal von Steuermitteln (6) und mit einer lumineszierenden Abdeckung (3) zum Umwandeln der genannten elektromagnetischen Strahlung in sichtbares Licht, **dadurch gekennzeichnet, dass** die lumineszierende Abdeckung wenigstens einen ersten Aktivator ($A_1$) und einen zweiten Aktivator ($A_2$) aufweist, wobei der genannte erste Aktivator und der genannte zweite Aktivator verschiedene Ansprechverhalten haben und die genannten Steuermittel dazu vorgesehen sind, das genannte Steuersignal zu Variieren, und zwar zur Steuerung des Spektrums ($Sp_{total}(\lambda)$) des genannten sichtbaren Lichtes für die genannte Lichtquelle.

2. Lichtquelle (1) nach Anspruch 1, wobei das genannte Steuersignal ein gepulstes Steuersignal (P) ist und die genannten Steuermittel (6) dazu vorgesehen sind, die Pulsbreite (W) des genannten gepulsten Steuersignals zu variieren.

3. Lichtquelle (1) nach Anspruch 1, wobei die genannte Leuchtanordnung (2) eine kontaktlose Lichtquelle ist, wie eine organische Leuchtdiode oder eine Halbleiterleuchtdiode, vorzugsweise aus InGaN oder AlInGaN Material.

4. Lichtquelle (1) nach Anspruch 1, wobei der genannte erste Aktivator ($A_1$) ein schneller Aktivator mit einer Ansprechzeit $\tau_{1/e}$ in dem Bereich von 10 ns - 100 µs und der genannte zweite Aktivator ($A_2$) ein langsamer Aktivator mit einer Ansprechzeit $\tau_{1/e}$ in dem Bereich von 10 µs - 100 ms ist.

5. Lichtquelle (1) nach Anspruch 4, wobei der genannte schnelle Aktivator ein Grünlicht emittierender Aktivator ist und der genannte langsame Aktivator ein Rotlicht emittierender Aktivator ist.

6. Lichtquelle (1) nach Anspruch 1, wobei der genannte erste Aktivator und der genannte zweite Aktivator Teil einer einzigen lumineszierenden Zusammensetzung sind.

7. Lichtquelle (1) nach Anspruch 6, wobei der genannte erste Aktivator und der genannte zweite Aktivator aus der Gruppe (erster Aktivator, zweiter Aktivator) gewählt werden, die Folgendes umfasst: ($Eu^{2+},Mn^{2+}$), ($Ce^{3+},Mn^{2+}$), $VO_4^{3-},Eu^{3+}$) und ($Bi^{3+},Eu^{3+}$) dotiert in ein Gastgebergitter, selektiert aus der Gruppe auf Basis von Sulfiden, Oxysulfiden, Oxiden, Oxynitriden und Nitriden.

8. Lichtquelle (1) nach Anspruch 1, wobei der genannte erste Aktivator und der genannte zweite Aktivator je einen Teil verschiedener leuchtender Zusammensetzungen bilden.

9. Lichtquelle nach Anspruch 8, wobei der genannte erste Aktivator aus der Gruppe mit $Eu^{2+}$, $Ce^{3+}$, $VO_4^{3-}$ und $Bi^{3+}$ dotiert in ein erstes Gastgebergitter aus Grünlicht emittierendem Material selektiert wird und wobei der genannte zweite Aktivator aus der Gruppe mit $Mn^{2+}$ und $Eu^{3+}$ dotiert in ein zweites Gastgebergitter aus Rotlicht emittierendem Material selektiert wird.

10. Verfahren zur Abdunkelung einer Lichtquelle mit wenigstens einer Leuchtanordnung (2), die imstande ist, elektromagnetische Strahlung in dem Bereich von nahezu Ultraviolett bis Blau zu emittieren, und zwar in Reaktion auf ein Steuersignal eines Steuermittels (6) und mit einer Abdeckung (3) zum Umwandeln der genannten elektromagnetischen Strahlung in sichtbares Licht, wobei das Verfahren den nachfolgenden Verfahrensschritt umfasst, und zwar das Variieren des genannten Steuersignals zur Steuerung des Spektrums des genannten sichtbaren Lichtes und **dadurch gekennzeichnet ist, dass** die lumineszierende Abdeckung wenigstens einen ersten Aktivator und einen zweiten Aktivator aufweist, wobei der genannte erste Aktivator und der genannte zweite Aktivator verschiedene Ansprechverhalten haben.

11. Verfahren nach Anspruch 10, mit dem Verfahrensschritt der Zuführung eines gepulsten Steuersignals zu der genannten Leuchtanordnung und dem Schritt des Variierens der Pulsbreite des genannten gepulsten Steuersignals.

## Revendications

1. Source de lumière (1) comprenant au moins un dispositif émettant de la lumière (2) qui est capable d'émettre du rayonnement électromagnétique dans la gamme comprise entre ultraviolet proche et bleu en réponse à un signal d'excitation de moyens d'excitation (6) et une couverture luminescente (3) pour convertir ledit rayonnement électromagnétique en lumière visible, **caractérisée en ce que** la couverture électroluminescente comprend au moins un premier activateur ($A_1$) et un deuxième activateur ($A_2$), dans laquelle ledit premier activateur et ledit deuxième activateur présentent des caractéristiques de réponse différentes et dans laquelle lesdits moyens d'excitation sont adaptés de manière à faire varier ledit signal d'excitation afin de commander le spectre ($Sp_{total}(\lambda)$) de ladite lumière

visible pour ladite source de lumière.

2. Source de lumière (1) selon la revendication 1, dans laquelle ledit signal d'excitation est un signal d'excitation pulsé (P) et dans laquelle lesdits moyens d'excitation (6) sont adaptés de manière à faire varier la largeur d'impulsion (W) dudit signal d'excitation pulsé.

3. Source de lumière (1) selon la revendication 1, dans laquelle ledit dispositif émettant de la lumière (2) est une source de lumière à état solide, telle qu'une diode électroluminescente organique ou une diode électroluminescente semi-conductrice, de préférence constituée d'un matériau InGaN ou AlInGaN.

4. Source de lumière (1) selon la revendication 1, dans laquelle ledit premier activateur ($A_1$) est un activateur rapide avec un temps de réponse $\tau_{1/e}$ dans la gamme comprise entre 10 nanosecondes et 100 microsecondes et dans laquelle ledit deuxième activateur ($A_2$) est un activateur lent avec un temps de réponse $\tau_{1/e}$ dans la gamme comprise entre 10 microsecondes et 100 millisecondes.

5. Source de lumière (1) selon la revendication 4, dans laquelle ledit activateur rapide est un activateur émettant de la lumière verte et dans laquelle ledit activateur lent est un activateur émettant de la lumière rouge.

6. Source de lumière (1) selon la revendication 1, dans laquelle ledit premier activateur et ledit deuxième activateur font partie d'une seule composition luminescente.

7. Source de lumière (1) selon la revendication 6, dans laquelle ledit premier activateur et ledit deuxième activateur sont sélectionnés parmi le groupe (premier activateur, deuxième activateur) comprenant ($Eu^{2+}$, $Mn^{2+}$), ($Ce^{3+}$, $Mn^{2+}$), ($VO_4^{3-}$, $Eu^{3+}$) et ($Bi^{3+}$, $Eu^{3+}$) étant dopés dans un réseau hôte qui est sélectionné parmi le groupe sur la base de sulfures, d'oxysulfures, d'oxydes, d'oxynitrures et de nitrures.

8. Source de lumière (1) selon la revendication 1, dans laquelle ledit premier activateur et ledit deuxième activateur font chacun partie de compositions luminescentes différentes.

9. Source de lumière selon la revendication 8, dans laquelle ledit premier activateur est sélectionné parmi le groupe comprenant $Eu^{2+}$, $Ce^{3+}$, $VO_4^{3-}$ et $Bi^{3+}$ étant dopés dans un premier réseau hôte de matériau émettant de la lumière verte et dans laquelle ledit deuxième activateur est sélectionné parmi le groupe comprenant $Mn^{2+}$ et $Eu^{3+}$ étant dopés dans un deuxième réseau hôte de matériau émettant de la lumière rouge.

10. Procédé de gradation d'une source de lumière comprenant au moins un dispositif émettant de la lumière (2) qui est capable d'émettre du rayonnement électromagnétique dans la gamme comprise entre ultraviolet proche et bleu en réponse à un signal d'excitation de moyens d'excitation (6) et une couverture luminescente (3) pour convertir ledit rayonnement électromagnétique en lumière visible, le procédé comprenant l'étape suivante consistant à faire varier ledit signal d'excitation pour commander le spectre de ladite lumière visible et étant **caractérisé en ce que** la couverture électroluminescente comprend au moins un premier activateur et un deuxième activateur, dans laquelle ledit premier activateur et ledit deuxième activateur présentent des caractéristiques de réponse différentes.

11. Procédé selon la revendication 10, comprenant l'étape suivante consistant à appliquer un signal d'excitation pulsé audit dispositif émettant de la lumière et à faire varier la largeur d'impulsion dudit signal d'excitation pulsé.

FIG. 1

FIG. 2

FIG. 3

FIG. 4

**EP 1 815 536 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20020158565 A

- US 4152711 A

**Non-patent literature cited in the description**

- **S. Nakamura et al.** *Appl. Phys. Lett.,* 1995, vol. 67, 1868